# FASCICULE DE BREVET EUROPEEN

(11) **EP 1 580 760 B1**
(45) Date de publication et mention de la délivrance du brevet: **06.04.2011**
(21) Numéro de dépôt: 05354008.4
(22) Date de dépôt: 22.02.2005
(51) Int. Cl.: G11C 11/16

(54) **Mémoire vive magnétorésistive à haute densité de courant**
MRAM mit hoher Stromdichte
MRAM with high current density

(30) Priorité: 05.03.2004 FR 0402354
(43) Date de publication de la demande: 28.09.2005
(73) Titulaire: Commissariat à l'Énergie Atomique et aux Énergies Alternatives, 75015 Paris (FR); CENTRE NATIONAL DE LA RECHERCHE SCIENTIFIQUE, 75794 Paris Cedex 16 (FR)
(72) Inventeur: Sousa, Ricardo, 38000 Grenoble (FR); Dieny, Bernard, 38250 Lans en Vercors (FR); Redon, Olivier, 38170 Seyssinet Pariset (FR)
(74) Mandataire: Hecké, Gérard

(56) Documents cités:
- WO-A-2004/057619
- FR-A- 2 832 542
- JP-A- 2003 298 025
- US-A1- 2003 031 045
- US-A1- 2003 086 313
- US-A1- 2003 189 853

## Description

### Domaine technique de l'invention

L'invention concerne une mémoire vive magnétorésistive comportant, sur un substrat semiconducteur, une matrice de cellules agencées en lignes et en colonnes et destinées chacune à stocker un bit d'information, chaque cellule d'une colonne comportant une jonction tunnel magnétique ayant une première borne et une seconde borne disposées de part et d'autre de la jonction tunnel magnétique et reliées respectivement à un conducteur de ligne et, par l'intermédiaire d'un transistor, muni d'une grille et de première et seconde électrodes, à un premier conducteur de colonne, associé à ladite colonne, et à une première colonne adjacente, la grille du transistor étant connectée à un conducteur de grille.

### État de la technique

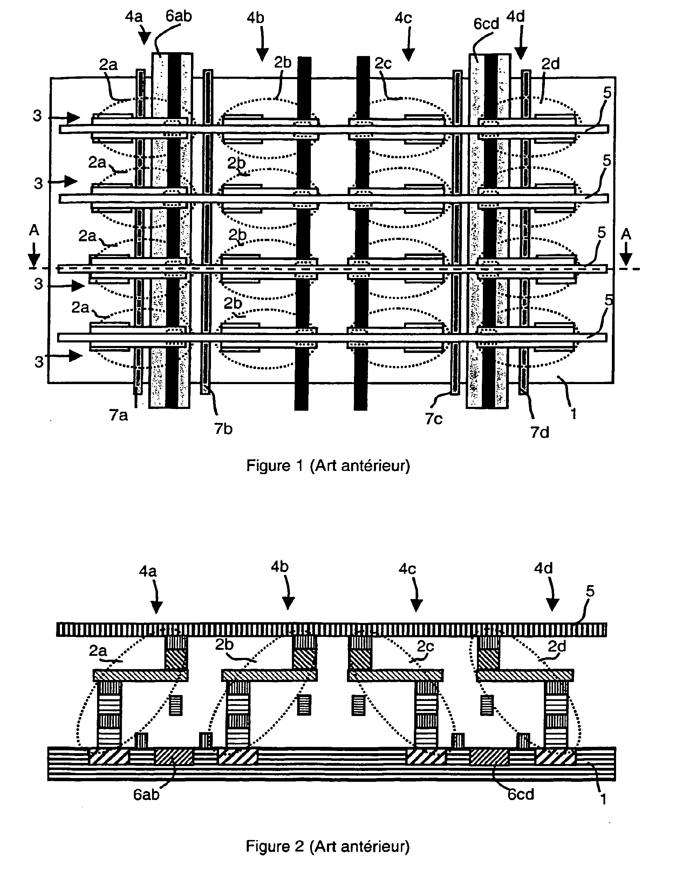

Sur les figures 1 et 2, une mémoire vive magnétorésistive comporte une matrice de cellules 2, disposées sur un substrat semiconducteur 1, agencées en lignes 3 et en colonnes 4a à 4d et destinées chacune à stocker un bit d'information. Chaque cellule d'une mémoire vive magnétorésistive comporte une jonction tunnel magnétique dont la résistance électrique est représentative de l'information à stocker.

Chaque jonction tunnel magnétique a une borne de ligne et une borne de colonne reliées respectivement à un conducteur de ligne 5 correspondant et, typiquement par l'intermédiaire d'un transistor, à un premier conducteur de colonne (6ab, 6cd) correspondant. Sur la figure 1, un conducteur de colonne 6ab est associé aux colonnes adjacentes 4a et 4b. De même, le conducteur de colonne 6cd est associé aux colonnes 4c et 4d. Ainsi, chaque paire de colonnes adjacentes est associée à un conducteur de colonne (6ab, 6cd) commun, tandis que chaque ligne est associée à un conducteur de ligne 5 correspondant.

Chaque transistor est classiquement muni; d'une première et d'une seconde électrode, reliées respectivement à la borne de colonne de la jonction tunnel correspondante et au conducteur de colonne 6 correspondant, ainsi que d'une grille constituant une électrode de commande. Les grilles des transistors d'une colonne (4a, 4b, 4c ou 4d) de cellules 2 sont connectées à un conducteur de grille (7a, 7b, 7c ou 7d) associé à la colonne (4a, 4b, 4c ou 4d). Ainsi, en appliquant des tensions électriques appropriées aux conducteurs de colonne 6, aux conducteurs de ligne 5 et aux conducteurs de grille 7, une jonction peut être sélectionnée et sa résistance peut être déterminée en fonction des tensions appliquées et du courant parcourant la jonction.

Pour certaines jonctions tunnel magnétiques, la densité de courant électrique parcourant la jonction peut atteindre une valeur de l'ordre de 10⁷ A/cm², notamment dans le cas de méthodes d'écriture d'informations basées sur des effets thermiques et/ou des effets d'injection de spin. La densité de courant dépend des matériaux et des épaisseurs des électrodes d'une jonction. Les densités de courant élevées donnent lieu à des valeurs de courant absolues également élevées. Les transistors doivent être conçus pour pouvoir supporter de tels courants et limitent ainsi la miniaturisation de la mémoire, pour un courant donné.

US 2003/0086313 et WO 2004/057619 décrivent des mémoires vives magnéto-résistives comprenant pour chaque cellule mémoire deux transistors d'accès telle que les electrodes drain/sources des deux transistors associés à une cellule sont alignées. Document FR 2 832 542 décrit une mémoire vive magnéto-résistive telle que décrit dans le préambule de la revendication 1.

### Objet de l'invention

L'invention a pour but de remédier à ces inconvénients et, en particulier, de réaliser une mémoire vive magnétorésistive de taille réduite.

Selon l'invention, ce but est atteint par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre schématiquement une mémoire vive magnétorésistive selon l'art antérieur.
La figure 2 représente, en coupe selon l'axe A-A, la mémoire selon la figure 1.
La figure 3 illustre, en une vue de dessus, un mode due réalisation particulier d'une mémoire vive magnétorésistive selon l'invention.
La figure 4 représente, en coupe selon l'axe B-B, la mémoire selon la figure 3.
Les figures 5 et 6 représentent, en coupe, deux autres exemples d'une mémoire vive magnétorésistive.

### Description de modes particuliers de réalisation

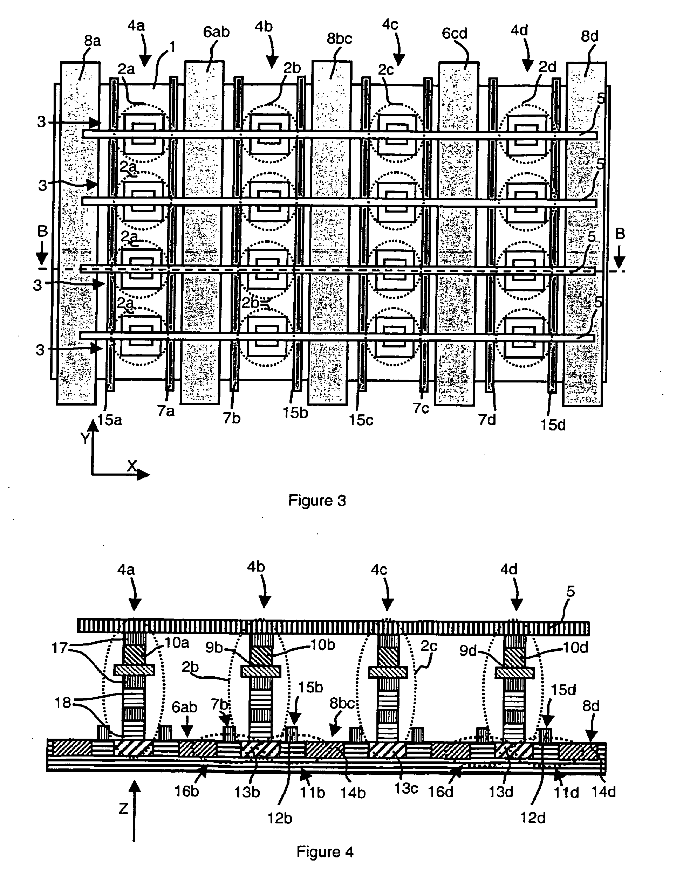

La mémoire vive magnétorésistive représentée sur les figures 3 et 4 comporte non seulement des premiers conducteurs de colonne 6ab et 6cd mais, également, des seconds conducteurs de colonne 8a 8bc et 8d. La borne de colonne 9b de chaque jonction tunnel 10b de la colonne 4b est alors connectée, par l'intermédiaire d'un transistor 16b, au premier conducteur de colonne 6ab et, par l'intermédiaire d'un transistor supplémentaire 11b, au second conducteur de colonne 8bc. Le second conducteur de colonne 8bc est associé à la fois à la colonne 4b et à une seconde colonne adjacente, notamment la colonne 4c. Le transistor supplémentaire 11b est muni d'une grille 12b et de première 13b et seconde 14b électrodes. La grille 12b du transistor supplémentaire 11b est connectée à un conducteur de grille supplémentaire 15b. Ainsi, chaque cellule 2 est reliée par l'intermédiaire de deux transistors 11 et 16, à un premier 6 et à un second 8 conducteur de colonne. Les conducteurs de grille 7 et 15 sont, de préférence, parallèles aux conducteurs de colonne 6 et 8. Chaque second conducteur de colonne 8bc associé à une colonne centrale 4b, c'est-à-dire non située aux extrémités, est associé à une autre colonne 4c adjacente.

Ainsi, un courant électrique traversant la jonction tunnel 10b est divisé en deux fractions, parcourant respectivement le transistor supplémentaire 11b et le transistor 16b. Chaque fraction de courant étant nettement inférieure au courant traversant la jonction 10b, les transistors 11b et 16b peuvent être de taille nettement inférieure aux transistors utilisés dans une mémoire selon l'art antérieur. Par exemple, la dimension d'un transistor suivant un axe Y, parallèle aux conducteurs de colonne, peut être réduite de sensiblement 50% et, ainsi le nombre de cellules 2 peut être sensiblement doublé par unité de longueur de colonne suivant l'axe Y. Les transistors supplémentaires 11, les seconds conducteurs de colonne 8 et les conducteurs de grille supplémentaires 15 nécessitent une augmentation de l'ordre de 20% de la dimension de la mémoire suivant un axe X, perpendiculaire à l'axe Y dans le plan du substrat 1, en appliquant des règles de conception actuelles d'une technologie CMOS-0,18µm. Ainsi, la surface moyenne d'une cellule 2 de stockage peut être réduite à 60% de la surface d'une cellule d'une mémoire selon l'art antérieur.

Un dispositif de commande, non représenté, de type classique, permet d'activer indépendamment les deux transistors 11b et 16b associés à une cellule 2b. Par exemple, lorsque le courant traversant la jonction 10b est inférieur au courant de saturation d'un transistor 11b ou 16b, un seul de ces transistors (11b ou 16b) peut être suffisant.

Sur les figures 3 et 4, la borne de colonne 9d de chaque jonction tunnel 10d de la colonne d'extrémité 4d est connectée, par l'intermédiaire d'un transistor supplémentaire 11d au second conducteur de colonne 8d qui est uniquement associé à la colonne 4d. La grille 12d du transistor supplémentaire 11d est connectée à un conducteur de grille supplémentaire 15d. Une configuration analogue s'applique pour la colonne d'extrémité 4a, comme représenté aux figures 3 et 4.

Les deux transistors 11b et 16b associés à une même cellule 2b ont, de préférence, une première électrode 13b commune, comme représenté à la figure 4.

De manière analogue, les deux transistors adjacents 11b et 16c associés respectivement à deux cellules adjacentes 2b et 2c d'une ligne 3 de cellules 2 ont, de préférence, une seconde électrode 14b commune. Comme représenté aux figures 3 et 4, le conducteur de colonne 8bc correspondant intègre, de préférence, la colonne de secondes électrodes 14b communes. Les premières 13 et secondes 14 électrodes peuvent respectivement être le drain et la source des transistors ou vice-versa.

Les jonctions tunnel magnétiques 10 sont, de préférence, connectées aux conducteurs de ligne 5 correspondants et aux transistors 11 et 16 associés par l'intermédiaire d'interconnexions 17 et de couches métalliques 18. Afin d'augmenter la température de la jonction tunnel 10 dans le cas d'une étape d'écriture assistée thermiquement, les interconnexions 17 peuvent comporter une ou plusieurs couches, disposées près de la jonction tunnel 10 et constituées par un matériau ayant une conductivité thermique faible, c'est-à-dire inférieure à 5W/mK, ce qui permet de confiner la chaleur dissipée dans la cellule. La couche de matériau ayant une conductivité thermique faible a, de préférence, une résistivité électrique faible, inférieure à 100µΩm, de manière à ce qu'elle représente une faible résistance en série avec la résistance de la jonction tunnel 10.

L'écriture d'informations dans la mémoire représentée aux figures 3 et 4 peut être effectuée par injection de spin. Ainsi, l'écriture est basée sur la direction du courant électrique parcourant une cellule pendant l'écriture. Cette technique présente l'avantage de ne pas nécessiter de conducteurs encombrants supplémentaires. Ainsi, comme représenté sur la figure 4, la jonction tunnel magnétique 10b d'une cellule 2b, la première électrode 13b, les interconnexions 17 et les couches métalliques 18 associées à la cellule 2b sont, de préférence, alignées selon un axe Z perpendiculaire au substrat 1.

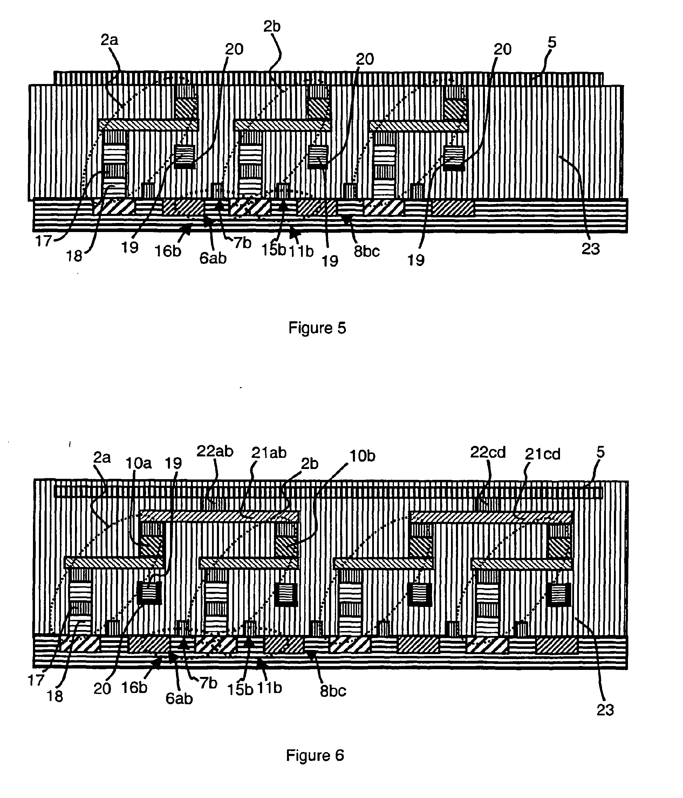

Sur les figures 5 et 6, la mémoire comporte une pluralité de conducteurs de courant 19 parallèles, isolés électriquement des jonctions tunnel magnétiques 10, associés chacun à une colonne 4 de cellules 2 et disposés de manière à pouvoir créer un champ magnétique à l'emplacement des jonctions tunnel magnétiques 10 des cellules 2 de la colonne 4 associée. Les conducteurs de courant 19 comportent, de préférence, un revêtement ferromagnétique 20, par exemple un matériau magnétique doux comme un alliage de nickel et de fer comportant 80% de nickel et 20% de fer. Cet alliage a une perméabilité magnétique élevée et une anisotropie magnétique faible, alignée, de préférence, selon l'axe longitudinal du conducteur de courant 19. Le revêtement ferromagnétique 20 couvre au moins une face du conducteur de courant 19 opposée à la face en regard de la jonction 10, comme représenté à la figure 5. Sur la figure 6, le revêtement recouvre également les faces latérales du conducteur de courant 19. Le revêtement 20 permet de focaliser les lignes de champ magnétique en direction de la jonction tunnel 10, créant ainsi le même champ que pour un conducteur non recouvert, mais avec un courant moindre.

Lors de l'écriture d'informations dans les mémoires représentées aux figures 5 et 6, un courant parcourant un conducteur de courant 19 créé un champ magnétique permettant de définir un état d'aimantation d'une jonction tunnel 10 dont la température est augmentée par effet Joule généré par un courant de chauffage traversant la jonction 10. Le courant de chauffage est contrôlé par les tensions appliquées au conducteur de ligne 5 correspondant, aux conducteurs de grille 6 et 8 et aux conducteurs de grille 7 et 15 associés. Lorsque le courant de chauffage est supérieur au courant de saturation d'un transistor 11 ou 16, les deux transistors 11 et 16 associés sont utilisés. La valeur maximale du courant de chauffage nécessaire au cours de l'écriture détermine la taille des transistors 11 et 16 et, ainsi, le nombre de cellules 2 par unité de longueur de colonne suivant l'axe Y.

Sur les figures 5 et 6, un conducteur de courant 19 est disposé entre les jonctions tunnel magnétiques 10 de la colonne de cellules 4 associée et le substrat 1. Les interconnexions 17 entre la jonction tunnel 10 et les transistors 11 et 16 sont alors décalées latéralement par rapport à la jonction tunnel 10 et au conducteur de courant 19 correspondant, qui sont alignés selon l'axe Z. Les conducteurs de courant 19 sont, de préférence, disposés très près des jonctions tunnel 10 afin de maximiser le champ magnétique agissant sur les jonctions 10. Par ailleurs, le courant parcourant un conducteur de courant 19 génère de la chaleur par effet Joule dans le conducteur de courant 19, ce qui permet de chauffer davantage la jonction tunnel 10 lors de l'écriture ou au moins de réduire les pertes thermiques. Ainsi, la résistivité du matériau des conducteurs de courant 19 est choisi de manière à maximiser l'effet Joule, sans, cependant, dépasser une tension maximum appropriée.

Sur la figure 6, deux jonctions tunnel magnétiques adjacentes 10a et 10b d'une ligne de cellules 3 sont connectées au conducteur de ligne 5 associé par l'intermédiaire d'une couche métallique commune 21ab et par une interconnexion commune 22ab. La couche métallique commune 21 (21ab, 21cd) est, de préférence, constituée par un matériau ayant une conductivité électrique élevée, par exemple par du cuivre ou de l'aluminium. Ainsi, lorsque les deux jonctions correspondantes 10a et 10b sont simultanément parcourues par des courants électriques respectifs, la chaleur dissipée dans l'interconnexion commune 22ab est proportionnelle au carré de la somme des courants ce qui permet de chauffer davantage les jonctions tunnel pendant les phases d'écriture sans augmenter le courant de chauffage passant par chaque jonction tunnel 10. Le nombre de jonctions tunnel magnétiques adjacentes 10 regroupées par l'intermédiaire d'une couche métallique commune 21 et par une interconnexion commune 22 peut être supérieur à deux et choisi, en combinaison avec la résistance Rv de l'interconnexion commune 22, de manière à ce que la chaleur dissipée dans l'interconnexion commune 22 soit comparable à la chaleur dissipée dans la jonction 10. Il est possible d'écrire dans une cellule ou dans plusieurs cellules simultanément. L'augmentation de la température de la jonction 10, due à la chaleur dissipée dans l'interconnexion commune 22ab, lors d'une phase d'écriture, permet de réduire le courant de chauffage et, ainsi, de concevoir des transistors de plus faible taille, ce qui permet d'augmenter le nombre de cellules 2 par unité de longueur de colonne suivant l'axe Y.

Lors d'une phase de lecture, il est possible d'activer simultanément les conducteurs de grille 7 et/ou 15 de plusieurs cellules regroupées ou d'activer uniquement les conducteurs de grille 7 et/ou 15 d'une seule cellule 2.

Quel que soit le mode de réalisation, la mémoire comporte, de préférence, comme représenté, à titre d'exemple, à la figure 5, un matériau isolant 23 de scellement recouvrant au moins la matrice de cellules 2, les conducteurs de colonne 6 et 8 et les conducteurs de courant 19 et pouvant même enrober les conducteurs de ligne 5 comme illustré à la figure 6. Le matériau isolant 23 de scellement a une conductivité thermique faible permettant, lors d'une étape d'écriture assistée thermiquement, de confiner la chaleur et, ainsi, d'obtenir une température augmentée donnée avec un courant de chauffage réduit. Le matériau isolant 23 est, par exemple, de la silice SiO₂ dont la conductivité thermique est de 1,4W/mK.

## Revendications

1. Mémoire vive magnétorésistive comportant, sur un substrat semiconducteur (1), une matrice de cellules (2) agencées en lignes (3) et en colonnes (4) et destinées chacune à stocker un bit d'information, chaque cellule (2b) d'une colonne (4b) comportant une jonction tunnel magnétique (10b) ayant une première borne et une seconde borne (9b) disposées de part et d'autre de la jonction tunnel magnétique et reliées respectivement à un conducteur de ligne (5) et, par l'intermédiaire d'un transistor (16b), muni d'une grille et de première (13b) et seconde électrodes, à un premier conducteur de colonne (6ab), associé à ladite colonne (4b) et à une première colonne adjacente (4a), la grille du transistor étant connectée à un conducteur de grille (7b), la seconde borne (9b) de chaque jonction tunnel (10b) d'une colonne (4b) étant connectée, par l'intermédiaire, d'un transistor supplémentaire (11b), muni d'une grille (12b) et de première (13b) et seconde électrodes (14b), à un second conducteur de colonne (8bc), la grille (12b) du transistor supplémentaire (11b) étant connectée à un conducteur de grille supplémentaire (15b), le courant électrique d'écriture traversant la jonction tunnel magnétique (10b) étant divisé, en plusieurs fractions, parcourant respectivement ledit transistor (16b) et le transistor supplémentaire (11b), mémoire **caractérisée en ce que** le transistor et le transistor supplémentaire de chaque cellule sont disposés de part et d'autre d'un axe reliant une pluralité de jonctions tunnel magnétiques d'une même colonne, les premières et secondes électrodes du transistor et du transistor supplémentaire étant alignées.

2. Mémoire selon la revendication 1, **caractérisée en ce que**, la matrice de cellules (2) comportant des colonnes centrales (4b) et deux colonnes d'extrémité (4a, 4d), le second conducteur (8bc) de chaque colonne centrale (4b) est associé à ladite colonne (4b) et à une seconde colonne adjacente (4c).

3. Mémoire selon l'une des revendications 1 et 2, **caractérisée en ce que** les conducteurs de grille (7, 15) sont parallèles au conducteur de colonne (6, 8).

4. Mémoire selon l'une quelconque des revendications 1 à 3, **caractérisée en ce que** les deux transistors (16b, 11b) associés à une cellule (2b) ont une première électrode (13b) commune,

5. Mémoire selon l'une quelconque des revendications 1 à 4, **caractérisée en ce que** deux transistors adjacents (11b, 16c) associés respectivement à deux cellules adjacentes (2b, 2c) d'une ligne (3) de cellules (2) ont une seconde électrode (14b) commune.

6. Mémoire selon la revendication 5, **caractérisée en ce qu'**un conducteur de colonne (8bc) intègre une colonne de secondes électrodes (14b) communes.

7. Mémoire selon l'une quelconque des revendications 1 à 6, **caractérisée en ce qu'**une jonction tunnel magnétique (10) est connectée au conducteur de ligne (5) correspondant et aux transistors (11, 16) associés par l'intermédiaire d'interconnexions (17) et de couches métalliques (18).

8. Mémoire selon la revendication 7, **caractérisée en ce que** les interconnexions (17) comportent une couche de matériau ayant une conductivité thermique faible.

9. Mémoire selon l'une des revendications 6 et 7, **caractérisée en ce que** la jonction tunnel magnétique (10) d'une cellule (2), une électrode (13) de transistor, les interconnexions (17) et les couches métalliques (18) associées sont alignées selon un axe (Z) perpendiculaire au substrat (1).

10. Mémoire selon l'une quelconque des revendication 1 à 8 **caractérisée en ce qu'**au moins deux jonctions tunnel magnétiques (10a, 10b) adjacentes d'une ligne (3) de cellules (2) sont connectées au conducteur de ligne (5) par l'intermédiaire d'une couche métallique commune (21 ab) et par une interconnexion commune (22ab).

11. Mémoire selon la revendication 10, **caractérisée en ce que** la couche métallique commune (21 ab) est constituée par un matériau ayant une conductivité électrique élevée.

12. Mémoire selon l'une quelconque des revendications 1 à 11, **caractérisée en ce qu'**elle comporte un matériau isolant (23) de scellement ayant une conductivité thermique faible et recouvrant au moins la matrice de cellules (2) et les conducteurs de colonne (6, 8).

13. Mémoire selon la revendication 12, **caractérisée en ce que** le matériau isolant (23) de scellement recouvre les conducteurs de ligne (5).

## Claims

1. Magnetoresistive random access memory comprising, on a semi-conducting substrate (1), a matrix of cells (2) arranged in rows (3) and columns (4) and each designed to store an information bit, each cell (2b) of a column (4b) comprising a magnetic tunnel junction (10b) having a first terminal and a second terminal (9b) separated by the magnetic tunnel junction and respectively connected to a row conductor (5) and, by means of a transistor (16b) equipped with a gate and with first (13b) and second electrodes, to a first column conductor (6ab), associated to said column (4b) and to a first adjacent column (4a), the gate of the transistor being connected to a gate conductor (7b), the second terminal (9b) of each tunnel junction (10b) of a column (4b) is connected, by means of an additional transistor (11 b) equipped with a gate (12b) and with first (13b) and second (14b) electrodes, to a second column conductor (8bc), the gate (12b) of the additional transistor (11b) being connected to an additional gate conductor (15b), the writing electrical current flowing through the magnetic tunnel junction (10b) being divided into several fractions, flowing through said transistor (16b) and the additional transistor (11 b), memory **characterized in that** the transistor and the additional transistor of each cell are separated by an axis connecting a plurality of magnetic tunnel junctions of a same column, les firsts and seconds electrodes of the transistor and the additional transistor being aligned.

2. Memory according to claim 1, **characterized in that**, the matrix of cells (2) comprising central columns (4b) and two end columns (4a, 4d), the second conductor (8bc) of each central column (4b) is associated to said column (4b) and to a second adjacent column (4c).

3. Memory according to one of the claims 1 and 2, **characterized in that** the gate conductors (7, 15) are parallel to the column conductor (6, 8).

4. Memory according to any one of the claims 1 to 3, **characterized in that** the two transistors (16b, 11 b) associated to a cell (2b) have a common first electrode (13b).

5. Memory according to any one of the claims 1 to 4, **characterized in that** two adjacent transistors (11 b, 16c) respectively associated to two adjacent cells (2b, 2c) of a line (3) of cells (2) have a common second electrode (14b).

6. Memory according to claim 5, **characterized in that** a column conductor (8bc) integrates a column of common second electrodes (14b).

7. Memory according to any one of the claims 1 to 6, **characterized in that** a magnetic tunnel junction (10) is connected to the corresponding line conductor (5) and to the associated transistors (11, 16) by means of interconnections (17) and metal layers (18).

8. Memory according to claim 7, **characterized in that** the interconnections (17) comprise a layer of material having a low thermal conductivity.

9. Memory according to one of the claims 6 and 7, **characterized in that** the magnetic tunnel junction (10) of a cell (2), a transistor electrode (13), the interconnections (17) and the associated metal layers (18) are aligned along an axis (Z) perpendicular to the substrate (1).

10. Memory according to any one of the claims 1 to 8, **characterized in that** at least two adjacent magnetic tunnel junctions (10a, 10b) of a line (3) of cells (2) are connected to the line conductor (5) by means of a common metal layer (21 ab) and by a common interconnection (22ab).

11. Memory according to claim 10, **characterized in that** the common metal layer (21 ab) is formed by a material having a high electrical conductivity.

12. Memory according to any one of the claims 1 to 11, **characterized in that** it comprises an insulating sealing material (23) having a low thermal conductivity and covering at least the matrix of cells (2) and the column conductors (6, 8).

13. Memory according to claim 12, **characterized in that** the insulating sealing material (23) covers the line conductors (5).

## Patentansprüche

1. Magnetoresistiver RAM-Speicher, der auf einem Halbleitersubstrat (1) eine Matrix von Zellen (2) aufweist, die in Zeilen (3) und in Spalten (4) angeordnet und dazu bestimmt sind, jeweils ein Informationsbit zu speichern, wobei jede Zelle (2b) einer Spalte (4b) einen magnetischen Tunnelübergang (10b) mit einer ersten Klemme und einer zweiten Klemme (9b) aufweist, die beiderseits des magnetischen Tunnelübergangs angeordnet und mit einem Zeilenleiter (5) bzw. über einen Transistor (16b), der mit einem Gate-Anschluss und einer ersten (13b) und einer zweiten Elektrode ausgestattet ist, mit einem ersten Spaltenleiter (6ab) verbunden sind, welcher der Spalte (4b) und einer ersten angrenzenden Spalte (4a) zugeordnet ist, wobei der Gate-Anschluss des Transistors an einen Gate-Leiter (7b) angeschlossen ist, wobei die zweite Klemme (9b) jedes Tunnelübergangs (10b) einer Spalte (4b) über einen zusätzlichen Transistor (11b), der mit einem Gate-Anschluss (12b) und einer ersten (13b) und einer zweiten Elektrode (14b) ausgestattet ist, an einen zweiten Spaltenleiter (8bc) angeschlossen ist, wobei der Gate-Anschluss (12b) des zusätzlichen Transistors (11b) an einen zusätzlichen Gate-Leiter (15b) angeschlossen ist, wobei der den magnetischen Tunnelübergang (10b) durchquerende elektrische Schreibstrom in mehrere Bruchteile unterteilt ist, die den Transistor (16b) bzw. den zusätzlichen Transistor (11b) durchfließen, wobei der Speicher **dadurch gekennzeichnet ist, dass** der Transistor und der zusätzliche Transistor jede Zelle beiderseits einer Achse angeordnet sind, die mehrere magnetische Tunnelübergänge einer gleichen Spalte verbinden, wobei die ersten und zweiten Elektroden des Transistors und des zusätzlichen Transistors ausgerichtet sind.

2. Speicher nach Anspruch 1, **dadurch gekennzeichnet, dass**, da die Matrix von Zellen (2) zentrale Spalten (4b) und zwei Endspalten (4a, 4d) aufweist, der zweite Leiter (8bc) jeder zentralen Spalte (4b) der Spalte (4b) und einer zweiten angrenzenden Spalte (4c) zugeordnet ist.

3. Speicher nach einem der Ansprüche 1 und 2, **dadurch gekennzeichnet, dass** die Gate-Leiter (7, 15) parallel zu dem Spaltenleiter (6, 8) sind.

4. Speicher nach einem der Ansprüche 1 bis 3, **dadurch gekennzeichnet, dass** die zwei einer Zelle (2b) zugeordneten Transistoren (16b, 11b) eine erste gemeinsame Elektrode (13b) haben.

5. Speicher nach einem der Ansprüche 1 bis 4, **dadurch gekennzeichnet, dass** zwei angrenzende Transistoren (11b, 16c), die zwei angrenzenden Zellen (2b bzw. 2c) einer Zeile (3) von Zellen (2) zugeordnet sind, eine zweite gemeinsame Elektrode (14b) haben.

6. Speicher nach Anspruch 5, **dadurch gekennzeichnet, dass** ein Spaltenleiter (8bc) eine Spalte von gemeinsamen zweiten Elektroden (14b) integriert.

7. Speicher nach einem der Ansprüche 1 bis 6, **dadurch gekennzeichnet, dass** ein magnetischer Tunnelübergang (10) an den entsprechenden Zeilenleiter (5) und an die zugeordneten Transistoren (11, 16) über Zusammenschaltungen (17) und Metallschichten (18) angeschlossen ist.

8. Speicher nach Anspruch 7, **dadurch gekennzeichnet, dass** die Zusammenschaltungen (17) eine Materialschicht mit einer niedrigen thermischen Leitfähigkeit aufweisen.

9. Speicher nach einem der Ansprüche 6 und 7, **dadurch gekennzeichnet**, das der magnetische Tunnelübergang (10) einer Zelle (2), eine Transistorelektrode (13), die Zusammenschaltungen (17) und die zugeordneten Metallschichten (18) nach einer Achse (Z) senkrecht zu dem Substrat (1) ausgerichtet sind.

10. Speicher nach einem der Ansprüche 1 bis 8, **dadurch gekennzeichnet, dass** wenigstens zwei angrenzende magnetische Übergänge (10a, 10b) einer Zeile (3) von Zellen (2) an den Zeilenleiter (5) über eine gemeinsame Metallschicht (21 ab) und durch eine gemeinsame Zusammenschaltung (22ab) angeschlossen sind.

11. Speicher nach Anspruch 10, **dadurch gekennzeichnet, dass** die gemeinsame Metallschicht (21 ab) durch ein Material mit einer hohen elektrischen Leitfähigkeit gebildet ist.

12. Speicher nach einem der Ansprüche 1 bis 14, **dadurch gekennzeichnet, dass** er ein Versiegelungsisoliermaterial (23) aufweist, das eine niedrige thermische Leitfähigkeit hat und wenigstens die Matrix von Zellen (2) und die Spaltenleiter (6, 8) überdeckt.

13. Speicher nach Anspruch 12, **dadurch gekennzeichnet, dass** das Versiegelungsisoliermaterial (23) die Zeilenleiter (5) überdeckt.
